# EUROPÄISCHE PATENTSCHRIFT

(11) **EP 1 234 332 B1**
(45) Veröffentlichungstag und Bekanntmachung des Hinweises auf die Patenterteilung: **17.01.2007**
(21) Anmeldenummer: 00988593.0
(22) Anmeldetag: 14.11.2000
(51) Int. Cl.: H01L 27/108, H01L 21/8242

(54) **DRAM-ZELLENSTRUKTUR MIT TUNNELBARRIERE**
DRAM CELL STRUCTURE WITH TUNNEL BARRIER
STRUCTURE DE CELLULE DRAM AYANT UNE BARRIERE DE TUNNEL

(30) Priorität: 15.11.1999 DE 19954869
(43) Veröffentlichungstag der Anmeldung: 28.08.2002
(73) Patentinhaber: Infineon Technologies AG, 81669 München (DE)
(72) Erfinder: HOFMANN, Franz, 80995 München (DE); RISCH, Lothar, 85579 Neubiberg (DE); ROESNER, Wolfgang, 85521 Ottobrunn (DE); SCHLOESSER, Till, 01109 Dresden (DE)
(74) Vertreter: Viering, Jentschura & Partner
(86) Internationale Anmeldenummer: PCT/DE2000/003982
(87) Internationale Veröffentlichungsnummer: WO 2001/037342

(56) Entgegenhaltungen:
- EP-A- 0 892 440
- EP-A- 0 908 954
- US-A- 5 355 330
- US-A- 5 949 103
- PATENT ABSTRACTS OF JAPAN vol. 1996, no. 08, 30. August 1996 (1996-08-30) & JP 08 097305 A (HITACHI LTD), 12. April 1996 (1996-04-12)

## Beschreibung

Schaltungsanordnung mit mindestens einem Kondensator und mindestens einem damit verbundenen Transistor.

Die Erfindung betrifft eine Schaltungsanordnung mit mindestens einem Kondensator und mindestens einem damit verbundenen Transistor.

Eine solche Schaltungsanordnung ist beispielsweise eine DRAM-Zellenanordnung mit Ein-Transistor-Speicherzellen. Die Speicherzellen umfassen jeweils einen Transistor und einen damit verbundenen Kondensator, auf dem die Information in Form einer Ladung gespeichert ist. Durch Ansteuerung des Transistors über eine Wortleitung kann die Ladung auf dem Kondensator über eine Bitleitung ausgelesen werden. Da die Ladung des Kondensators die Bitleitung treibt, ist das ausgelesene Signal an der Bitleitung umso größer je höher die Ladung ist, die beim Auslesen durch den Transistor fließt. Zur Erhöhung dieser Ladung wird derzeit versucht, die Kapazität des Kondensators zu erhöhen. Da zugleich eine hohe Packungsdichte der DRAM-Zellenanordnung angestrebt wird, werden Kondensatoren mit kleinem Platzbedarf vorgeschlagen, die zur Vergrößerung ihrer Oberflächen komplizierte dreidimensionale Ausbuchtungen aufweisen oder die zur Erhöhung der Dielektrizitätskonstanten ihrer Kondensatordielektrika zum Teil aus neuartigen, prozeßtechnisch schwer handhabbaren Materialien bestehen.

In E. Snow et al "A metal/oxide tunneling transistor", Applied Physics Letters, Vol. 72, No. 23, 1998, 3071, wird ein Transistor beschrieben, der ein erstes Source-/Drain-Gebiet, ein zweites Source-/Drain-Gebiet und ein dazwischen angeordnetes Kanalgebiet aufweist. Das gesamte Kanalgebiet wird durch eine Tunnelbarriere aus isolierendem Material aufgefüllt. Das erste Source-/Drain-Gebiet und das zweite Source-/Drain-Gebiet bestehen aus Metall. Auf dem ersten Source-/Drain-Gebiet, dem Kanalgebiet und dem zweiten ource-/Drain- Gebiet ist ein Gatedielektrikum des Transistors angeordnet.

Auf dem Gatedielektrikum ist eine Gateelektrode des Transistors angeordnet. Wird an die Gateelektrode eine geeignete Spannung angelegt, so können Elektronen durch die Tunnelbarriere tunneln und es fließt Strom durch den Transistor.

Eine ähnliche Schaltungsanordnung ist in EP 0 892 440 A1, EP 0 908 954 A2, und JP 08 097305 offenbart.

Der Erfindung liegt das Problem zugrunde, eine Schaltungsanordnung mit mindestens einem Kondensator und mindestens einem damit verbundenen Transistor anzugeben, bei der bei gleicher Kapazität des Kondensators im Vergleich zum Stand der Technik mehr Ladung vom Kondensator durch den Transistor fließt, wenn der Transistor geöffnet wird.

Der Erfindung liegt die Erkenntnis zugrunde, daß Ladung auf einem Kondensator aufgrund von Leckströmen zwischen dem Laden und dem eigentlichen Entladen des Kondensators verringert wird. Die Ladung, die beim Öffnen des Transistors vom Kondensator durch den Transistor fließt, ist folglich kleiner als die Ladung auf dem Kondensator unmittelbar nachdem der Kondensator geladen wurde.

Das Problem wird gelöst durch eine Schaltungsanordnung gemäß dem Anspruch 1.

Aufgrund der Tunnelbarriere weist der Transistor im gesperrten Zustand so gut wie keinen Leckstrom auf. Die Ladung auf dem Kondensator kann also zwischen dem Laden und dem Entladen des Kondensators aufgrund der Tunnelbarriere nicht durch den gesperrten Transistor in Form von Leckstromabfliessen. Da die isolierende Struktur die erste Kondensatorelektrode, auf der die Ladung gespeichert wird, und das damit verbundene ersteSource-/Drain-Gebiet vollständig umgibt, kann auch sonst kaum Ladung durchLeckströme verlorengehen. Da die Ladung zwischen dem Laden und Entladen nicht verringert wird, kann besonders viel Ladung durch den Transistorfliessen, wenn ergeöffnet wird.

Der Transistor ist beispielsweise auf einer isolierenden Schicht, die mindestens teilweise Teil der isolierenden Struktur ist, angeordnet. Die isolierende Schicht trennt den Transistor und folglich auch das ersteSource-/Drain-Gebiet von darunterliegendem Material.

Beispielsweise ist die isolierende Schicht auf einem Substrat angeordnet. Der Transistor kann beispielsweise alsDünnfilmtransistor auf der isolierenden Schicht angeordnet sein. Dazu ist auf der isolierenden Schicht eine Schicht aus Polysilizium angeordnet. Das erste Source-/Drain-Gebiet und das zweite Source-/Drain-Gebiet sind von einem ersten Leitfähigkeitstyp dotierte Teile der Schicht aus Polysilizium. Das Kanalgebiet ist ein von einem zweiten, zum ersten Leitfähigkeitstyp entgegengesetzten Leitfähigkeitstyp dotierter Teil der Schicht aus Polysilizium. Auf der Schicht aus Polysilizium sind das Gatedielektrikum und die Gateelektrode angeordnet. Alternativ kann der Transistor, der auf der isolierenden Schicht angeordnet ist, wie folgt ausgestaltet sein: Das erste Source-/Drain-Gebiet und das zweite Source-/Drain-Gebiet können aus Metall bestehen. Die Tunnelbarriere füllt das gesamte Kanalgebiet aus. Mindestens auf dem Kanalgebiet sind das Gatedielektrikum und die Gateelektrode angeordnet.

Der Transistor kann als MOS-Transistor ausgestaltet sein.

Beispielsweise ist der Transistor in einer dünnen Schicht aus monokristallinem Silizium angeordnet, die zu einem SOI-Substrat gehört. Die isolierende Schicht, die Teil des SOI-Substrats ist, ist unter der dünnen Schicht aus monokristallinem Silizium angeordnet und trennt diese vom restlichen SOI-Substrat.

Das Substrat kann auch ein SOI-ähnliches Substrat sein. Beispielsweise handelt es sich eigentlich um zwei Substrate aus Silizium, die derart miteinander verbunden sind, daß zwischen ihnen die isolierende Schicht angeordnet ist. Zur Herstellung eines solchen SOI-ähnlichen Substrats wird beispielsweise ein erste Substrat mit einer ersten Teilschicht aus isolierendem Material und ein zweites Substrat mit einer zweiten Teilschicht aus isolierendem Material versehen. Anschließend werden die beiden Substrate so zusammengefügt, daß die beiden Teilschichten aufeinandertreffen, und erhitzt, so daß aus den beiden Teilschichten die isolierenden Schicht erzeugt wird. Das eine der beiden Substrate wird anschließend gedünnt, bis nur noch eine dünne Schicht aus monokristallinem Silizium auf der isolierenden Schicht bestehen bleibt. Das andere der beiden Substrate wirkt dabei als Trägersubstrat.

Der Kondensator ist beispielsweise über der isolierenden Schicht angeordnet.

Alternativ sind die zweite Kondensatorelektrode und mindestens ein Teil der ersten Kondensatorelektrode unter der isolierenden Schicht angeordnet. Zur Verbindung der ersten Kondensatorelektrode mit dem ersten Source-/Drain-Gebiet weist die isolierende Schicht mindestens eine Öffnung auf, die die isolierende Schicht durchtrennt.

In der Öffnung kann ein Kontakt oder ein Teil der ersten Kondensatorelektrode angeordnet sein.

Ein solcher Kondensator kann in einer Vertiefung eines Substrats angeordnet sein.

Der Transistor kann als planarer Transistor ausgestaltet sein. In diesem Fall grenzt die Tunnelbarriere mit ihrem unteren Ende an die isolierende Schicht an. Ein oberes Ende der Tunnelbarriere grenzt an das Gatedielektrikum an.

Zur Erhöhung der Packungsdichte der Schaltungsanordnung ist es vorteilhaft, wenn der Transistor als vertikaler Transistor ausgestaltet ist. Das erste Source-/Drain-Gebiet, das Kanalgebiet und das zweite Source-/Drain-Gebiet sind übereinander angeordnet. Entweder ist das erste Source-/Drain-Gebiet über dem zweiten Source-/Drain-Gebiet angeordnet oder umgekehrt.

Bestehen das erste Source-/Drain-Gebiet und das zweite Source-/Drain-Gebiet aus Metall, so füllt die Tunnelbarriere das ganze Kanalgebiet aus und grenzt an das erste Source-/Drain-Gebiet und an das zweite Source-/Drain-Gebiet an.

Ist der Transistor als vertikaler MOS-Transistor ausgestaltet, und ist das zweiteSource-/Drain-Gebiet über dem ersten Source-/Drain-Gebiet angeordnet, so grenzt die Tunnelbarriere vorzugsweise an das zweite Source-/Drain-Gebiet an. Ein Teil des Kanalgebiets, in dem die Tunnelbarriere nicht angeordnet ist, grenzt an die Tunnelbarriere und an das erste Source /Drain-Gebiet an. Die Tunnelbarriere ist also auf dem Teil des Kanalgebiets angeordnet, der vorzugsweise ausmonokri- stallinem Silizium besteht. Diese Anordnung ist wesentlich leichter zu erzeugen, als wenn die Tunnelbarriere unter einem Teil des Kanalgebiets aus monokristallinem Silizium angeordnet ist, da es schwierig ist, monokristallines Silizium auf isolierendem Material zu erzeugen.

Grenzt die Tunnelbarriere an das zweite Source/Drain-Gebiet aber nicht an das erste Source/Drain-Gebiet an, so ist das Gatedielektrikum Teil der isolierenden Struktur. Ist die Tunnelbarriere im Kanalgebiet angeordnet ohne an das erste Source-/Drain-Gebiet oder an das zweite Source-/Drain-Gebiet anzugrenzen, so ist ein Teil des Gatedielektrikums, der zwischen der Tunnelbarriere und dem ersten Source-/Drain-Gebiet angeordnet ist, Teil der isolierenden Struktur. In beiden Fällen ist ein Teil des Kanalgebiets im isolierten Bereich angeordnet, der von der isolierenden Struktur umgeben wird.

Die Tunnelbarriere kann an das ersteSource-/Drain-Gebiet angrenzen, wobei ein Teil des Kanalgebiets, in dem die Tunnelbarriere nicht angeordnet ist, an das zweite Source-/Drain Gebiet angrenzt.

ZurErhöhung der Kanalweite des vertikalen Transistors ist es vorteilhaft, wenn die Gateelektrode das Kanalgebietringförmig seitlich umgibt.

Die Schaltungsanordnung ist beispielsweise eine DRAM Zellenanordnung mit Speicherzellen, wobei der Transistor und der Kondensator Teil einer der Speicherzellen sind. Die Spei cherzelle ist so ausgestaltet, daß zu speichernde Information in Form einer Ladung auf dem Kondensator gespeichert wird, und daß beim Auslesen der Information der Transistor geöffnet wird und Ladung vom Kondensator durch den Transistor fließt. Gerade für eine Speicherzellenanordnung ist die erfindungsgemäße Ausgestaltung des Kondensators und des Transistors besonders vorteilhaft, da auf dem Kondensator gespeicherte Ladung durch Leckströme nicht verlorengeht.

Beispielsweise sind die Gateelektroden der Transistoren der Speicherzellen mit Wortleitungen verbunden. Die zweiten Kondensatorelektroden der Kondensatoren der Speicherzellen sind mit quer zu den Wortleitungen verlaufenden Bitleitungen verbunden. Pro Speicherzelle sind also ein Transistor und ein Kondensator vorgesehen.

Alternativ sind die zweiten Source-/Drain-Gebiete der Transistoren der Speicherzellen und nicht die zweiten Kondensatorelektroden mit den Bitleitungen verbunden.

Im folgenden wird eine weitere mögliche Ausgestaltung der Speicherzelle beschrieben:

Die Speicherzelle umfaßt einen Speichertransistor und den Transistor, die in Reihe zwischen der Bitleitung und einem Spannungsanschluß geschaltet sind. Eine Diode ist zwischen einem Source-/Drain-Gebiet des Speichertransistors, das mit dem Transistor verbunden ist, und einer Gateelektrode des Speichertransistors geschaltet. Die erste Kondensatorelektrode des Kondensators ist mit der Gateelektrode des Speichertransistors verbunden. Die Gateelektrode des Transistors ist mit der quer zur Bitleitung verlaufenden Wortleitung verbunden. Beim. Auslesen der Information, die in Form einer Ladung auf dem Kondensator gespeichert wird, wird der Transistor geoffnet, so daß Ladung vom Kondensator über die Diode durch den Transistor fließt. Zugleich fließt Ladung zwischen dem Spannungsanschluß und der Bitleitung durch den Transistor und durch den Speichertransistor, wenn dieser bei ausreichender Ladung auf dem Kondensator geöffnet ist.

Im folgenden wird ein Ausführungsbeispiel der Erfindung anhand der Figuren näher erläutert.
- Figur 1: zeigt einen Querschnitt durch ein erstes Substrat, nachdem eine Schutzschicht, Vertiefungen, ein Kondensatordielektrikum, erste Kondensatorelektroden und eine erste Teilschicht einer isolierenden Schicht erzeugt wurden.
- Figur 2: zeigt den Querschnitt aus Figur 1 und einen Querschnitt durch ein zweites Substrat, nachdem auf dem zweiten Substrat eine zweite Teilschicht der isolierenden Schicht erzeugt wurde, die beiden Substrate miteinander verbunden wurden, das zweite Substrat gedünnt wurde und eine Nitrid-Schicht und eine Schicht aus Polysilizium erzeugt wurden.
- Figur 3: zeigt den Querschnitt aus Figur 2, nachdem eine erste Hilfsschicht, erste Gräben, leitende Strukturen und dotierte Gebiete erzeugt wurden.
- Figur 4a: zeigt den Querschnitt aus Figur 3, nachdem Isolationen, erste Füllstrukturen, zweite Gräben (in Figur 4b dargestellt), erste Source/Drain-Gebiete, zweite Source/Drain-Gebiete und Kontakte erzeugt wurden.
- Figur 4b: zeigt einen vom Querschnitt aus Figur 4a senkrechten Querschnitt durch die beiden Substrate nach den Prozeßschritten aus Figur 4a.
- Figur 4c: zeigt eine Aufsicht auf die beiden Substrate, in der die Vertiefungen, die ersten Gräben und die zweiten Gräben dargestellt sind.
- Figur 5a: zeigt den Querschnitt aus Figur 4a, nachdem die erste Hilfsschicht entfernt wurde, ein Gatedielektrikum (in Figur 5b dargestellt), Wortleitungen und zweite Füllstrukturen erzeugt wurden.
- Figur 5b: zeigt den Querschnitt aus Figur 4b nach den Prozeßschritten aus Figur 5a.
- Figur 6a: zeigt den Querschnitt aus Figur 5a, nachdem Bitleitungen, isolierende Spacer, eine zweite Hilfsschicht, ein Zwischenoxid, Wortleitungskontakte und Leitungen erzeugt wurden.
- Figur 6b: zeigt den Querschnitt aus Figur 5b nach den Prozeßschritten aus Figur 6a.
- Figur 6c: zeigt die Aufsicht aus Figur 4c, in der die Kontakte, die zweiten Source/Drain-Gebiete, an den Flanken der ersten Gräben angeordnete Teile der Isolationen, die Wortleitungen und ein Wortleitungskontakt dargestellt sind.

Die Figuren sind nicht maßstabsgetreu.

Ausführungsbeispiel ist eine DRAM-Zellenanordnung. Zur Verdeutlichung des Aufbaus der DRAM-Zellenanordnung wird im folgenden Verfahren zu seiner Herstellung beschrieben:

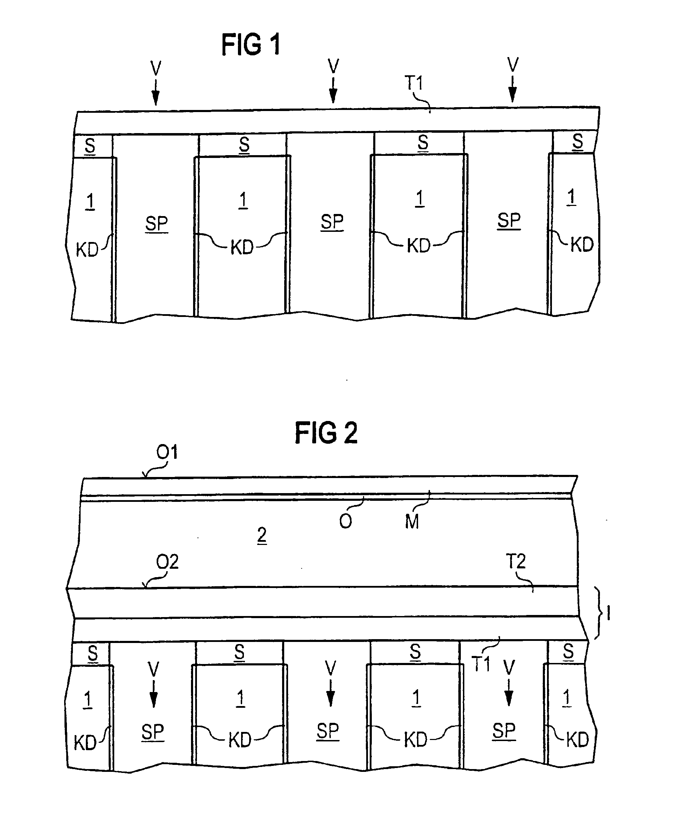

Es wird ein ca. 400 µm dickes erstes Substrat 1 aus n-dotiertem Silizium bereitgestellt. Die Dotierstoffkonzentration beträgt ca. 10²⁰ cm⁻³. Zur Erzeugung einer Schutzschicht S wird Siliziumnitrid in einer Dicke von ca. 50 nm abgeschieden (siehe Figur 1).

Durch maskiertes Ätzen werden im ersten Substrat 1 ca. 6 µm tiefe Vertiefungen V erzeugt (siehe Figur 1). Die Vertiefungen V weisen kreisförmige horizontale Querschnitte auf, deren Durchmesser ca. 150 nm beträgt. Die Vertiefungen V sind in Reihen und Spalten angeordnet. Abstände zwischen zueinander benachbarten Vertiefungen V betragen ca. 150 nm.

Zur Erzeugung eines Kondensatordielektrikums KD von Kondensatoren wird Siliziumnitrid in einer Dicke von ca. 5 nm abgeschieden und durch thermische Oxidation ca. 2 nm tief aufoxidiert (siehe Figur 1).

Zur Erzeugung von ersten Kondensatorelektroden SP der Kondensatoren wird insitu n-dotiertes Polysilizium in einer Dicke von ca. 200 nm abgeschieden und durch chemisch-mechanisches Polieren planarisiert, bis die Schutzschicht S freigelegt wird (siehe Figur 1). Das erste Substrat 1 wirkt als zweite Kondensatorelektrode aller Kondensatoren.

Zur Erzeugung einer ersten Teilschicht T1 einer isolierenden Schicht I wird SiO₂ in einer Dicke von ca. 200 nm abgeschieden und durch chemisch-mechanisches Polieren planarisiert. Die erste Teilschicht T1 der isolierenden Schicht I ist ca. 100 nm dick.

Es wird ein ca. 400 µm dickes zweites Substrat 2 aus p-dotiertem Silizium bereitgestellt. Die Dotierstoffkonzentration beträgt ca. 10¹⁷ cm⁻³. Auf dem zweiten Substrat 2 wird eine ca. 100 nm dicke zweite Teilschicht T2 der isolierenden Schicht I aufgebracht, indem SiO₂ in einer Dicke von ca. 200 nm abgeschieden und durch chemisch-mechanisches Polieren planarisiert wird (siehe Figur 2).

Das erste Substrat 1 und das zweite Substrat 2 werden derart aufeinander gestapelt, daß die erste Teilschicht T1 auf die zweite Teilschicht T2 der isolierenden Schicht I auftrifft. Durch einen Temperschritt bei ca. 900°C werden die erste Teilschicht T1 und die zweite Teilschicht T2 fest miteinander verbunden und bilden die isolierende Schicht I (siehe Figur 2).

Anschließend wird das zweite Substrat 2 gedünnt, wobei das erste Substrat 1 als stabilisierende Trägerplatte wirkt. Nach dem Dünnen ist das zweite Substrat 2 ca. 900 nm dick (siehe Figur 2).

Durch Abscheidung wird eine ca. 3nm dicke Nitrid-Schicht O aus Siliziumnitrid erzeugt. Zur Erzeugung einer Schicht aus Polysilizium M wird insitu n-dotiertes Polysilizium in einer Dicke von ca. 200 nm auf der Nitrid-Schicht O abgeschieden (siehe Figur 2). Die Dotierstoffkonzentration der Schicht aus Polysilizium M beträgt ca. 10²⁰ cm⁻³. Das zweite Substrat 2 weist an einer ersten Oberfläche Ol die Schicht aus Polysilizium M auf und an einer der ersten Oberfläche O1 gegenüberliegenden Oberfläche 02 die isolierende Schicht I.

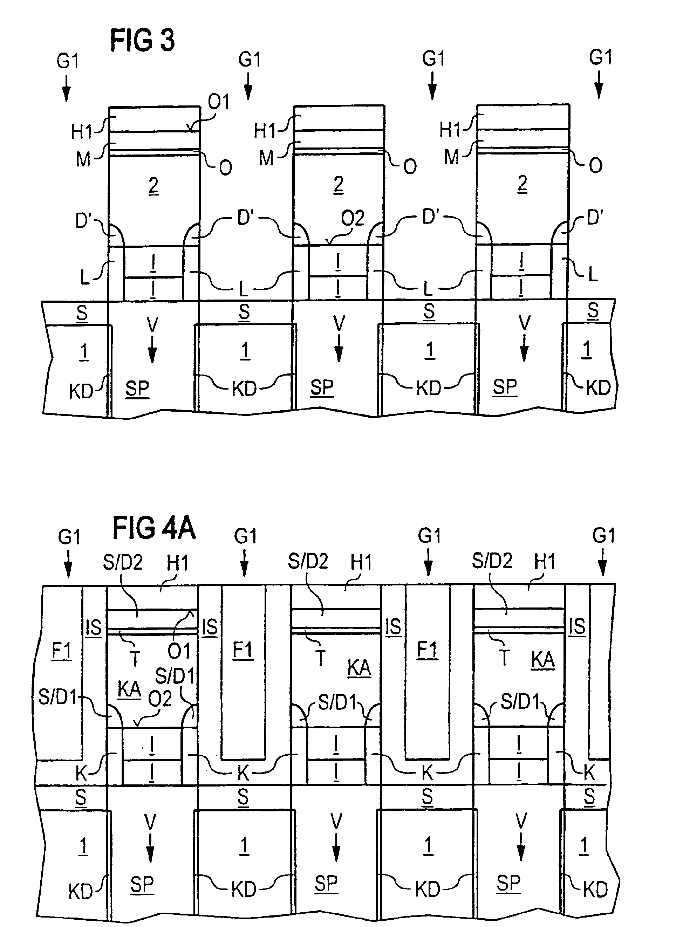

Zur Erzeugung einer ersten Hilfsschicht H1 wird Siliziumnitrid in einer Dicke von ca. 100 nm auf der Schicht aus Polysilizium M abgeschieden (siehe Figur 3).

Mit Hilfe einer ersten Grabenmaske aus Fotolack (nicht dargestellt) werden in dem zweiten Substrat 2 erste Gräben Gl erzeugt, die zunächst die erste Hilfsschicht Hl, die Schicht aus Polysilizium M, die Nitrid-Schicht und das zweite Substrat 2 durchtrennen. Anschließend wird SiO₂ geätzt, so daß die ersten Gräben G1 derart vertieft werden, daß sie die isolierende Schicht I durchtrennen (siehe Figur 3).

Durch isotropes Atzen von SiO₂ werden an Flanken der ersten Gräben G1 angrenzende Teile der isolierenden Schicht I entfernt (siehe Figur 3). Als Atzmittel ist z. B. HF geeignet.

Die entfernten Teile der isolierenden Schicht I werden durch leitende Strukturen L ersetzt, indem insitu n-dotiertes Polysilizium in einer Dicke von ca. 50 nm abgeschieden und rückgeätzt wird, bis die Schutzschicht S freigelegt wird (siehe Figur 3).

Anschließend wird durch thermische Oxidation ein ca. 5 nm dickes Oxid (nicht dargestellt) erzeugt. Dabei diffundiert Dotierstoff aus den leitenden Strukturen L in das zweite Substrat 2 und bildet dort streifenförmige dotierte Gebiete D (siehe Figur 3).

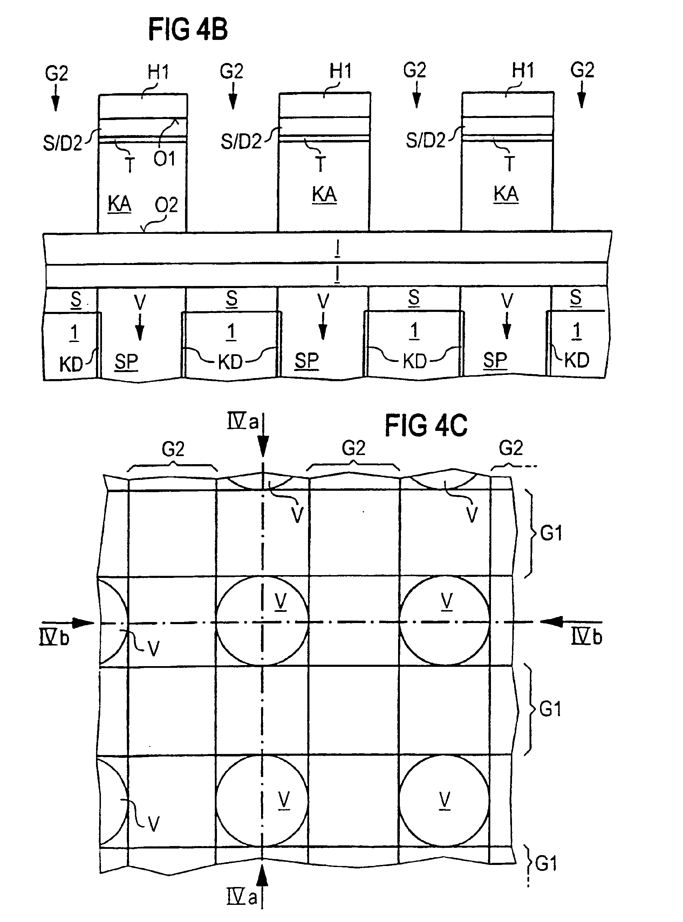

Zur Erzeugung von Isolationen IS wird Siliziumnitrid in einer Dicke von ca. 50 nm abgeschieden. Anschließend wird SiO₂ in einer Dicke von ca. 100 nm abgeschieden, so daß die ersten Gräben G1 gefüllt werden. Durch chemisch-mechanisches Polieren werden SiO₂ und Siliziumnitrid abgetragen, bis die erste Hilfsschicht H1 freigelegt wird. Dadurch werden aus dem Siliziumnitrid die Isolationen IS erzeugt, die in den ersten Gräben G1 angeordnet sind, die Flanken und die Böden der ersten Gräben G1 bedecken und Teile aufweisen, die sich in den ersten Gräben G1 gegenüberliegen. Aus dem SiO₂ entstehen in den ersten Gräben G1 erste Füllstrukturen F1 (siehe Figur 4a).

Mit Hilfe einer zweiten Grabenmaske aus Fotolack werden im zweiten Substrat 2 zweite Gräben G2 erzeugt, indem Siliziumnitrid, Polysilizium und SiO₂ geätzt werden, bis die isolierende Schicht I freigelegt wird (siehe Figuren 4b und 4c).

Aus den dotierten Gebieten D, die durch die zweiten Gräben G2 strukturiert werden, entstehen erste Source/Drain-Gebiete S/D1 der Transistoren. Aus der Schicht aus Polysilizium M, die durch die ersten Gräben G1 und die zweiten Gräben G2 strukturiert wird, entstehen zweite Source/Drain-Gebiete S/D2 von Transistoren. Aus der Nitrid-Schicht O, die durch die ersten Gräben G1 und die zweiten Gräben G2 strukturiert wird, entstehen Tunnelbarrieren T. Zwischen den ersten Source/Drain-Gebieten S/D1 und den zweiten Source/Drain-Gebieten S/D2 angeordnete Teile des zweiten Substrats 2 wirken als Kanalgebiete KA der Transistoren. Die Tunnelbarrieren T sind in den Kanalgebieten KA angeordnet.

Durch die zweiten Gräben G2 werden an Böden der zweiten Gräben G2 Teile der leitenden Strukturen L freigelegt. Diese Teile der leitenden Strukturen L werden durch Ätzen mit z. B. He, HBr, Cl₂, C₂F₆ entfernt. Die leitenden Strukturen L werden dadurch strukturiert und bilden voneinander getrennte Kontakte K, die die ersten Source/Drain-Gebiete S/D1 jeweils mit den darunter liegenden ersten Kondensatorelektroden SP verbinden (siehe Figur 4a).

Die entfernten Teile der leitenden Strukturen L werden durch isolierendes Material ersetzt, indem SiO₂ in einer Dicke von ca. 150 nm abgeschieden, so daß die zweiten Gräben G2 gefüllt werden, und chemisch-mechanisch planarisiert, bis die erste Hilfsschicht H1 freigelegt wird. Durch Ätzen mit z.B. CHF₃, O₂ wird die erste Hilfsschicht H1 entfernt. Anschließend wird SiO₂ ca. 300 nm tief rückgeätzt, so daß sich die Böden der zweiten Gräben G2 wieder auf ihrer ursprünglichen Höhe befinden. Beim Rückätzen des SiO₂ werden auch die ersten Füllstrukturen F1 rückgeätzt, so daß sich eine gitterförmige Vertiefung bildet, die die Kanalgebiete KA der Transistoren seitlich umgibt.

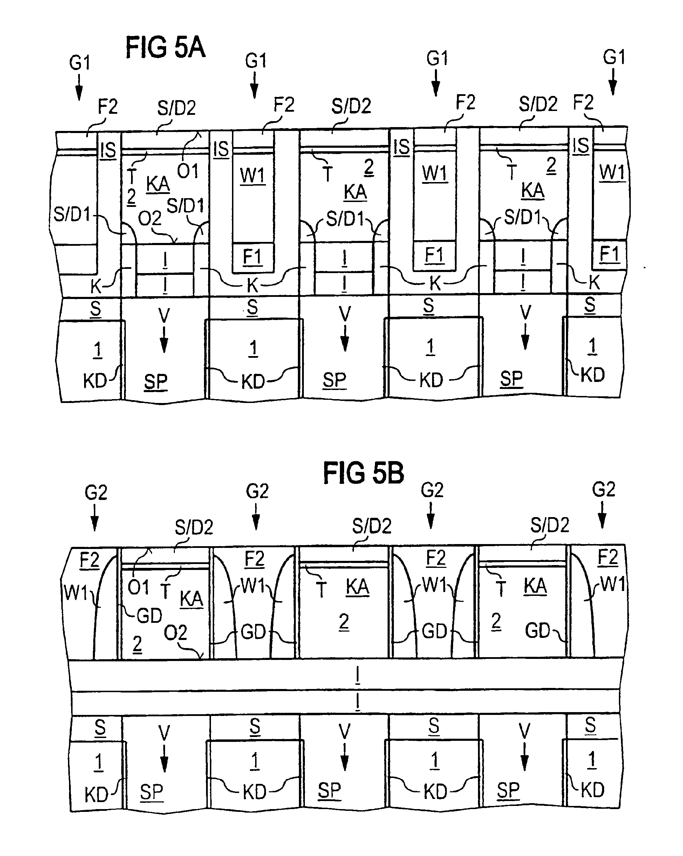

Durch thermische Oxidation werden an freiliegenden Flächen der Kanalgebiete KA ein ca. 5 nm dickes Gatedielektrikum GD erzeugt. Das Gatedielektrikum GD ist an Teilen der Flanken der zweiten Gräben G2 angeordnet (siehe Figur 5b).

Zur Erzeugung von Wortleitungen W1 wird insitu n-dotiertes Polysilizium in einer Dicke von ca. 50 nm abgeschieden, so daß die ersten Gräben G1 gefüllt werden, während die zweiten Gräben G2 nicht gefüllt werden. Anschließend wird Polysilizium ca. 100 nm weit rückgeätzt, bis die Böden der zweiten Gräben G2 freigelegt werden. Aus dem Polysilizium entstehen dadurch die Wortleitungen W1 (siehe Figuren 5a und 5b).

Zur Erzeugung von zweiten Füllstrukturen F2 wird SiO₂ in einer Dicke von ca. 100 nm abgeschieden und durch chemisch-mechanisches Polieren planarisiert, bis die zweiten Source/Drain-Gebiete S/D2 freigelegt werden (siehe Figuren 5a und 5b).

Zur Erzeugung von Bitleitungen B wird Wolfram in einer Dicke von ca. 100 nm abgeschieden. Darüber wird zur Erzeugung einer zweiten Hilfsschicht H2 Siliziumnitrid in einer Dicke von ca. 50 nm abgeschieden.

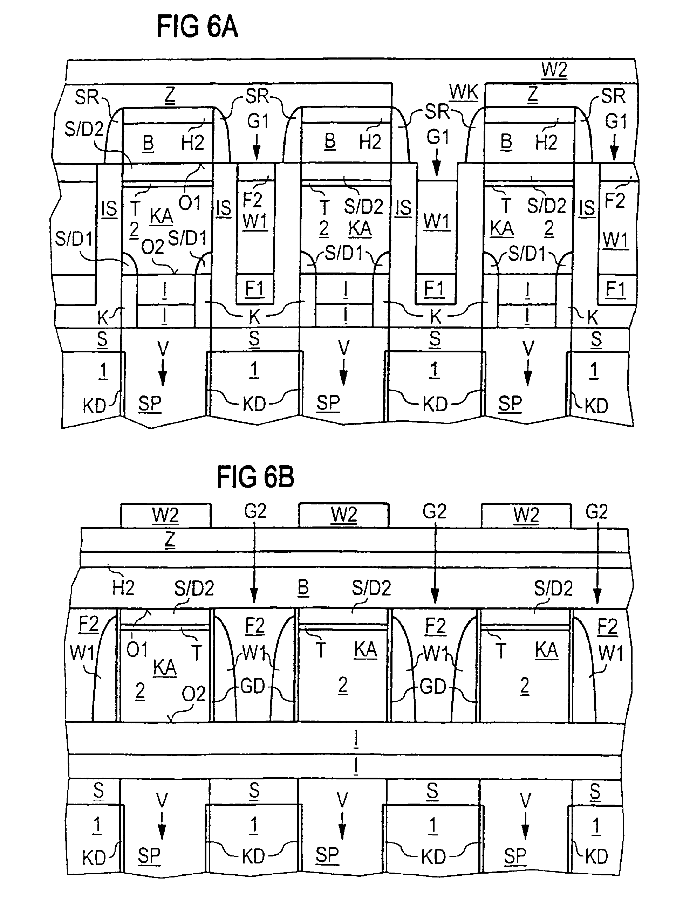

Mit Hilfe einer Maske aus Fotolack werden die zweite Hilfsschicht H2 und das Wolfram strukturiert, so daß aus dem Wolfram die Bitleitungen B erzeugt werden, die ca. 150 nm breit sind, parallel zu den ersten Gräben G1 verlaufen, zwischen den ersten Gräben G1 angeordnet sind, an die zweiten Source/Drain-Gebiete S/D2 angrenzen und von der zweiten Hilfsschicht H2 bedeckt sind (siehe Figuren 6a und 6b).

Zum Abkapseln der Bitleitungen B wird Siliziumnitrid in einer Dicke von ca. 30 nm abgeschieden und rückgeätzt, bis die zweiten Füllstrukturen F2 freigelegt werden. Aus dem Siliziumnitrid werden dadurch isolierende Spacer SR erzeugt, die die Bitleitungen B seitlich schützen (siehe Figur 6a).

Anschließend wird ein ca. 100 nm dickes Zwischenoxid Z erzeugt, indem SiO₂ in einer Dicke von ca. 200 nm abgeschieden und durch chemisch-mechanisches Polieren planarisiert wird (siehe Figuren 6a und 6b).

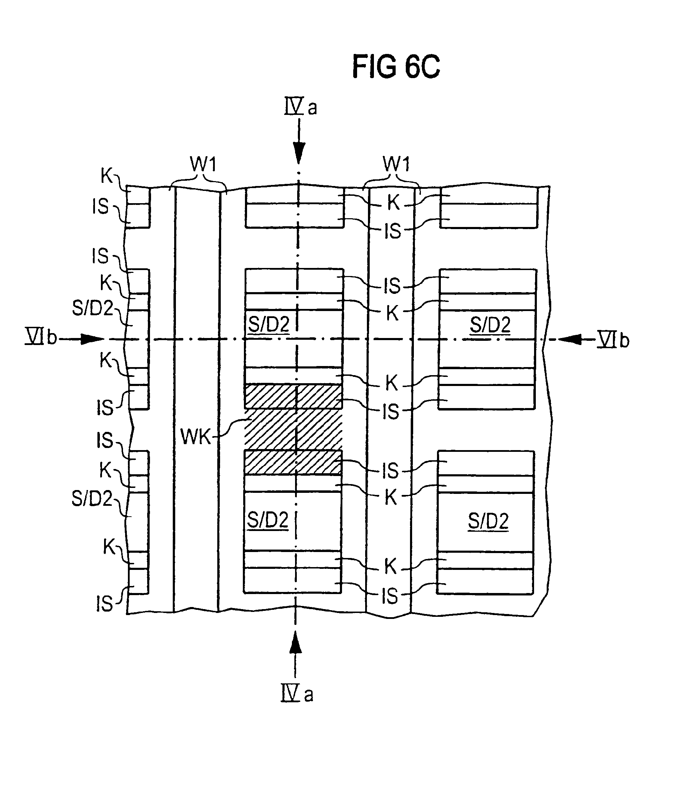

Zur Erzeugung von Wortleitungskontakten WK werden im Zwischenoxid Z Kontaktlöcher zu in den ersten Gräben G1 angeordneten Teilen der Wortleitungen W1 geöffnet. Abstände zwischen entlang der Wortleitung W1 zueinander benachbarten Kontaktlöchem betragen ca. 20 µm. Beim Öffnen der Kontaktlöcher werden auch die entsprechenden zweiten Füllstrukturen F2 entfernt, so daß die Teile der Wortleitungen W1 freigelegt werden. Anschließend wird Wolfram in einer Dicke von ca. 200 nm abgeschieden, so daß die Kontaktlöcher mit den Wortleitungskontakten WK gefüllt werden. Mit Hilfe einer Maske aus Fotolack (nicht dargestellt) wird Wolfram strukturiert, so daß parallel zu den Wortleitungen W1 verlaufende Leitungen W2 erzeugt werden (siehe Figuren 6a und 6b und 6c).

Durch das beschriebene Verfahren wird eine DRAN-Zellenanordnung erzeugt, bei der eine Speicherzelle einen Transistor und einen damit verbundenen Kondensator umfaßt. Für jede Speicherzelle gilt: die erste Kondensatorelektrode SP, ein aus Silizium bestehender Teil des Kanalgebiets KA, das erste Source/Drain-Gebiet S/D1 und die Kontakte K werden vollständig von einer isolierenden Struktur umgeben, die aus dem Kondensatordielektrikum KD, der Tunnelbarriere T, dem Gatedielektrikum, der isolierenden Schicht I, den Isolationen IS und der Schutzschicht S besteht.

Es sind viele Variationen des Ausführungsbeispiels denkbar, die ebenfalls im Rahmen der Erfindung liegen. So können Abmessungen der beschriebenen Schichten, Gebiete, Strukturen, Leitungen und Kontakte an die jeweiligen Erfordernisse angepaßt werden.

## Patentansprüche

1. Schaltungsanordnung mit mindestens einem Kondensator und mindestens einem damit verbundenen Transistor,
- bei der der Transistor ein erstes Source/Drain-Gebiet (s/D1), ein daran angrenzendes Kanalgebiet (KA), ein daran angrenzendes zweites Source/Drain-Gebiet (S/D2), ein Gatedielektrikum (GD) und eine Gateelektrode aufweist,
- bei der eine erste Kondensatorelektrode (SP) des Kondensators mit dem ersten Source/Drain-Gebiet (S/D1) verbunden ist,
- bei der eine isolierende Struktur einen Bereich der schaltungsanordnung vollständig isolierend umgibt und bildet somit einen isolierten Bereich,
- bei der mindestens die erste Kondensatorelektrode (SP) und das erste Source/Drain-Gebiet (S/D1) im isolierten Bereich angeordnet sind,
- bei der die Gateelektrode das Kanalgebier (KA) ringförmig seitlich umgibt und derart konzipiert ist, dass, wenn eine geeignete Spannung an die Gateelektrode angelegt wird, Ladung durch die Tunnelbarriere (T) tunnelt,
- bei der ein Kondensatordielektrikum (KD) die erste Kondensatorelektrode (SP) von der zweiten Kondensatorelektrode trennt und Teil der isolierenden Struktur ist.
- bei der mindestens das zweite Source/Drain-Gebiet (S/D2) und eine zweite Kondensatorelektrode des Kondensators außerhalb des isolierten Bereichs angeordnet sind, charakterisiert **dadurch,** dass eine einzelne Tunnelbarriere (T) Teil der isolierenden Struktur ist und diese Tunnelbarriere (T) angrenzend zum zweiten source/Drain-Gebiet (S/D2), welches über dem ersten Source/Drain-Gebiet (S/D1) angeordnet ist, im Kanalgebiet (KA) angeordnet ist.

2. Schaltungsanordnung nach Anspruch 1,
- bei der der Transistor auf einer isolierenden Schicht (I), die mindestens teilweise Teil der isolierenden Struktur ist, angeordnet ist.

3. Schaltungsanordnung nach Anspruch 2,
- bei der die zweite Kondensatorelektrode und mindestens ein Teil der ersten Kondensatorelektrode (SP) unter der isolierenden Schicht (I) angeordnet sind,
- bei der die isolierende Schicht (I) zur Verbindung der ersten Kondensatorelektrode (SP) mit dem ersten Source/Drain-Gebiet (S/D1) mindestens eine Öffnung aufweist, die die isolierende Schicht (I) durchtrennt.

4. Schaltungsanordnung nach Anspruch 3,
- bei der der Teil des Kanalgebiets (KA), in dem die Tunnelbarriere (T) nicht angeordnet ist, an die Tunnelbarriere (T) und an das erste Source/Drain-Gebiet (S/Dl) angrenzt.

5. Schaltungsanordnung nach einem der Ansprüche 1 bis 4,
- die eine DRAM-Zellenanordnung mit Speicherzellen ist,
- bei der der Transistor und der Koindensator Teil einer der Speicherzellen sind.

6. Schaltungsanordnung nach Anspruch 5,
- bei der die Gateelektroden der Transistoren der Speicherzellen mit Wortleitungen (W1) verbunden sind,
- bei der die zweiten Kondensatorelektroden der Kondensatoren der Speicherzellen oder die zweiten Source/Drain-Gebiete (S/D2) der Transistoren der Speicherzellen mit quer zu den wortleitungen (W1) verlaufenden Bitleitungen (B) verbunden sind.

7. Schaltungsanordnung nach einem der Ansprüche 1 bis 6, bei der der Transistor als MOS-Transistor ausgestaltet ist.

## Claims

1. A circuit arrangement, comprising at least one capacitor and at least one transistor connected thereto,
- in which the transistor comprises a first source/drain region (S/D1), a channel region (KA) adjoining the first source/drain region (S/D1), a second source/drain region (S/D2) adjoining the channel region (KA), a gate dielectric (GD) and a gate electrode,
- in which a first capacitor electrode (SP) of the capacitor is connected to the first source/drain-region (S/D1),
- in which an insulating structure surrounds, completely insulating, a portion of the circuit arrangement thus forming an insulated region,
- in which at least the first capacitor electrode (SP) and the first source/drain region (S/D1) are arranged in the insulated region,
- in which the gate electrode circularly surrounds the channel region (KA) on the side and is designed in such a way that, if a suitable voltage is applied to the gate electrode, charge tunnels through the tunneling barrier (T),
- in which a capacitor dielectric (KD) separats the first capacitor electrode (SP) from the second capacitor electrode and is a part of the insulating structure,
- in which at least the second source/drain region (S/D2) and a second capacitor electrode of the capacitor are arranged outside the insulated region, **characterized in that** a single tunneling barrier (T) is part of the insulating structure and said tunneling barrier (T), is arranged in the channel region (KA) adjoining the second source/drain region (S/D2), which, in turn, is arranged above the first source/drain region (S/D1).

2. A circuit arrangement according to claim 1,
- in which the transistor is arranged on an insulating layer (I), which is at least partially part of the insulating structure.

3. A circuit arrangement according to claim 2,
- in which the second capacitor electrode and at least a part of the first capacitor electrode (SP) are arranged below the insulating layer (I),
- in which the insulating layer (I) comprises at least one opening, for connecting the first capacitor electrode (SP) to the first source/drain region (S/D1), the opening cutting through the insulating layer (I).

4. A circuit arrangement according to claim 3,
- in which the part of the channel region (KA), in which the tunneling barrier (T) is not arranged, adjoins the tunneling barrier (T) and the first source/drain (S/D1) region.

5. A circuit arrangement according to anyone of claims 1 to 4,
- which is a DRAM cell arrangement having memory cells,
- in which the transistor and the capacitor are part of one of the memory cells.

6. A circuit arrangement according to claim 5,
- in which the gate electrodes of the transistors of the memory cells are connected to word lines (W1),
- in which the second capacitor electrodes of the capacitors of the memory cells or the second source/drain regions (S/D2) of the transistors of the memory cells are connected to bit lines (B1) running transversely with respect to the word lines (W1).

7. A circuit arrangement according anyone of claims 1 to 6, in which the transistor is configured as a MOS transistor.

## Revendications

1. Montage comprenant au moins un condensateur et au moins un transistor qui y est relié,
- dans lequel le transistor a une première zone de source/drain (S/D1), une zone (KA) de canal qui en est voisine, une deuxième zone (S/D2) de source/drain qui en est voisine, un diélectrique (GD) de grille et une électrode de grille,
- dans lequel une première électrode (SP) du condensateur est reliée à la première zone (S/D1) de source/drain,
- dans lequel une structure isolante entoure d'une manière complètement isolante une région du montage et forme ainsi une région isolée,
- dans lequel au moins la première électrode (SP) de condensateur et la première zone (S/D1) de source/drain sont disposés dans la région isolée,
- dans lequel l'électrode de grille entoure latéralement en forme d'anneau la zone (K) de canal et est conçue de façon à ce lorsqu'une tension appropriée est appliquée à l'électrode de grille, la charge passe par l'effet tunnel dans la barrière (T) de tunnel,
- dans lequel un diélectrique (KD) de condensateur sépare la première électrode (SP) de condensateur et la deuxième électrode de condensateur et fait partie de la structure isolante,
- dans lequel au moins la deuxième zone (S/D2) de source/drain et une deuxième électrode du condensateur sont disposés à l'extérieur de la région isolée, **caractérisé en ce que**,
- une barrière (T) de tunnel individuelle fait partie de la structure isolante et cette barrière (T) de tunnel est disposée dans la zone (KA) de canal au voisinage de la deuxième zone de source/drain (S/D2) qui est disposée au dessus de la première zone de source/drain (S/D1).

2. Montage selon la revendication 1,
dans lequel le transistor est disposé sur une couche (I) isolante qui fait partie au moins en partie de la structure isolante.

3. Montage selon la revendication 2,
dans lequel la deuxième électrode de condensateur et au moins une partie de la première électrode (SP) de condensateur sont disposés sous la couche (I) isolante, montage dans lequel la couche (I) isolante a, pour relier la première électrode (SP) de condensateur à la première zone (S/D1) source/drain, au moins une ouverture qui traverse la couche (I) isolante.

4. Montage selon la revendication 3,
dans lequel la partie de la zone (KA) de canal, dans laquelle n'est pas disposée la barrière (T) de tunnel, est voisine de la barrière (T) du tunnel et de la première zone (S/D1) de source/drain.

5. Montage selon l'une des revendications 1 à 4,
- qui est un dispositif de cellules (DRAM) ayant des cellules de mémoire,
- dans lequel le transistor et le condensateur font partie de l'une des cellules de mémoire.

6. Montage selon la revendication 5,
dans lequel les électrodes de grilles des transistors des cellules de mémoires sont reliées à des lignes (W1) de mots,
dans lequel les deuxièmes électrodes de condensateur des condensateurs des cellules de mémoire ou les deuxièmes zones (S/D2) de source/drain des transistors des cellules de mémoire sont reliées aux lignes (B) de bits s'étendant transversalement aux lignes (W1) de mots.

7. Montage selon l'une des revendications 1 à 6,
dans lequel le transistor est constitué sous la forme de transistor MOS.
